# EUROPÄISCHE PATENTSCHRIFT

(11) **EP 1 278 250 B1**
(45) Veröffentlichungstag und Bekanntmachung des Hinweises auf die Patenterteilung: **16.12.2009**
(21) Anmeldenummer: 02010870.0
(22) Anmeldetag: 15.05.2002
(51) Int. Cl.: H01L 33/00, H01L 25/13, C09K 11/64, C09K 11/08

(54) **Beleuchtungseinheit mit mindestens einer LED als Lichtquelle**
Illumination device with at least one LED as the light source
Unité d'éclairage comportant au moins une diode électroluminescente comme source de lumière

(30) Priorität: 16.07.2001 DE 10133352
(43) Veröffentlichungstag der Anmeldung: 22.01.2003
(73) Patentinhaber: Osram Gesellschaft mit beschränkter Haftung, 81543 München (DE)
(72) Erfinder: Ellens, Andries, Dr., 2561 SL Den Haag (NL); Huber, Günter, 86529 Schrobenhausen (DE); Kummer, Franz, Dr., 80797 München (DE)

(56) Entgegenhaltungen:
- US-A- 6 069 440
- VAN KREVEL: "On new rare-earth doped M-Si-Al-O-N materials" 2000, TU EINDHOVEN , XP008060386 * Seite 145 - Seite 157 *
- VAN KREVEL J W H ET AL: "Long wavelength Ce<3+> emission in Y-Si-O-N materials" JOURNAL OF ALLOYS AND COMPOUNDS, ELSEVIER SEQUOIA, LAUSANNE, CH, Bd. 268, Nr. 1-2, 27. März 1998 (1998-03-27), Seiten 272-277, XP004130688 ISSN: 0925-8388
- SHEN Z ET AL: "EU-DOPED ALPHA-SIALON AND RELATED PHASES" JOURNAL OF MATERIALS SCIENCE LETTERS, CHAPMAN AND HALL LTD. LONDON, GB, Bd. 17, Nr. 20, 15. Oktober 1998 (1998-10-15), Seiten 1703-1706, XP000851300 ISSN: 0261-8028
- MANDAL H ET AL: "Preparation of multiple-cation alfa-SIAlON ceramics containing Lanthanum" JOURNAL OF THE AMERICAN CERAMIC SOCIETY, BLACKWELL PUBLISHING, MALDEN, MA, US, Bd. 82, Nr. 1, 1999, Seiten 229-232, XP002343000 ISSN: 0002-7820
- CAO G Z ET AL: "'-SIALON CERAMICS: A REVIEW" CHEMISTRY OF MATERIALS, AMERICAN CHEMICAL SOCIETY, WASHINGTON, US, Bd. 3, Nr. 2, 1. März 1991 (1991-03-01), Seiten 242-252, XP000246430 ISSN: 0897-4756
- IZHEVSKIY^1 V A ET AL: "Progress in SiAlON ceramics" JOURNAL OF THE EUROPEAN CERAMIC SOCIETY, ELSEVIER SCIENCE PUBLISHERS, BARKING, ESSEX, GB, Bd. 20, Nr. 13, November 2000 (2000-11), Seiten 2275-2295, XP004216509 ISSN: 0955-2219

## Beschreibung

### Technisches Gebiet

Die Erfindung geht aus von einer Beleuchtungseinheit mit mindestens einer LED als Lichtquelle gemäß dem Oberbegriff des Anspruchs 1. Es handelt sich dabei insbesondere um eine im Sichtbaren oder Weiß emittierende LED auf Basis einer primär UV/blau emittierenden LED.

### Stand der Technik

Eine Beleuchtungseinheit mit mindestens einer LED als Lichtquelle, die beispielsweise weißes Licht abgibt, wird derzeit vorwiegend durch die Kombination einer im Blauen bei etwa 460 nm emittierenden Ga(In)N-LED und eines gelb emittierenden YAG:Ce³⁺-Leuchtstoffs realisiert (US 6 069 440, US 5 998 925 und EP 862 794). Dabei werden für eine gute Farbwiedergabe oft zwei verschiedene Gelb-Leuchtstoffe verwendet wie in WO-A 01/08453 beschrieben. Problematisch dabei ist, dass die beiden Leuchtstoffe oft unterschiedliches Temperaturverhalten zeigen, auch wenn ihre Struktur ähnlich ist. Ein bekanntes Beispiel ist der im Gelben lumineszierende Ce-dotierte Y-Granat (YAG:Ce) und der im Vergleich dazu längerwellig lumineszierende (Y,Gd)-Granat. Dies führt zu Farbortschwankungen und Änderungen der Farbwiedergabe bei unterschiedlichen Betriebstemperaturen.

Aus der Veröffentlichung "On new rare-earth doped M-Si-Al-O-N materials" von van Krevel, TU Eindhoven 2000, XP 008060386, ISBN 90-386-2711-4, Kapitel 11, ist eine Klasse von Leuchtstoffmaterialien bekannt, die in Abkürzung ihrer Struktur als Sialone (α-Sialone) bezeichnet werden. Mittels Dotierung mit Eu wird eine Emission im Bereich von 560 bis 590 nm erzielt bei Anregung mit 365 nm oder 254 nm.

### Darstellung der Erfindung

Es ist Aufgabe der vorliegenden Erfindung, eine Beleuchtungseinheit mit mindestens einer LED als Lichtquelle gemäß dem Oberbegriff des Anspruchs 1 bereitzustellen, die sich durch hohe Konstanz bei wechselnden Betriebstemperaturen auszeichnet. Eine weitere Aufgabe ist, eine Beleuchtungseinheit bereitzustellen, die weiß emittiert und insbesondere eine hohe Farbwiedergabe und hohe Ausbeute besitzt.

Diese Aufgabe wird durch die kennzeichnenden Merkmale des Anspruchs 1 gelöst. Besonders vorteilhafte Ausgestaltungen finden sich in den abhängigen Ansprüchen.

Erfindungsgemäß wird als Leuchtstoff für die LED-basierte Beleuchtungseinheit ein Sialon verwendet, das gelb-orange emittiert und aus der Klasse der Eu-aktivierten Sialone stammt, wobei das Sialon der Formel M_{p/2}Si_{12-p-q}Al_{p+q}O_{q}N_{16-q}:Eu²⁺ gehorcht, mit M = Ca einzeln oder in Kombination mit Sr und Mg, mit q = 0 bis 2,5 und p = 0,5 bis 3. Bevorzugt wird ein hoher Wert für p gewählt, nämlich p = 2 bis 3, und ein relativ niedriger Wert für q, nämlich q = 0 bis 1. Statt reinem AI kann insbesondere eine Mischung AI, Ga mit bis zu 20 mol-% Anteil des Ga verwendet werden.

Der Eu-Anteil, der einen Teil des Kations M ersetzt, sollte bei 0,5 bis 15 %, bevorzugt 1 bis 10 %, des M-Kations liegen, wodurch eine besonders genaue Wahl der Emissionswellenlänge getroffen werden kann und auch die Lichtausbeute optimiert werden kann. Ein steigender Eu-Gehalt bewirkt im allgemeinen eine Verschiebung der Peakemission zu längeren Wellenlängen hin. Überraschend hat sich herausgestellt, dass auch eine wechselnde Konzentration des Kations M die Wellenlänge der Peakemission verschiebt. Bei niedriger Konzentration des M-Kations kann man eine gute Absorption durch das Eu-lon dadurch erhalten, dass man den Anteil des Eulons über 10 % des M-Kations wählt.

Besondere Vorteile dieses Leuchtstoffs in Verbindung mit einer LED-basierten Beleuchtungseinheit sind seine hohe Effizienz, seine überragende Temperaturstabilität (keine Empfindlichkeit gegen Änderungen der Betriebstemperatur) und eine überraschend hohe Löschtemperatur der Lumineszenz sowie die damit erzielbare hohe Farbwiedergabe, insbesondere bei Kombination mit mindestens einem weiteren Leuchtstoff. Die Löschtemperatur, also die Temperatur, bei der die Lumineszenz aufgrund der zugeführten Wärme zerstört wird, ist sogar so hoch, dass sie außerhalb des vorgewählten Messbereichs (maximal 140 °C) lag.

Ein weiterer Vorteil dieser Leuchtstoffklasse ist, dass bereits das Ausgangsmaterial (insbesondere Si₃N₄) in feinstdisperser Form vorliegt. Damit ist ein Mahlen des Leuchtstoffs nicht notwendig. Dagegen müssen konventionelle Leuchtstoffe wie YAG:Ce gemahlen werden, damit sie im Gießharz dispergiert bleiben und nicht auf den Boden absinken. Dieser Mahlvorgang führt häufig zu Effizienzverlusten. Der erfindungsgemäße Leuchtstoff hat trotz feiner Korngröße des Ausgangsmaterials eine überraschend hohe Absorption. Dieser Leuchtstoff muss daher nicht mehr gemahlen werden, wodurch ein Arbeitsgang gespart wird und keine Effizienzverluste auftreten. Typische mittlere Korngrößen des Leuchtstoffs liegen bei 0,5 bis 5 µm.

Neben der Erzeugung einer farbigen Lichtquelle durch Anregung mittels UV-Strahlung oder blauer Primäremission einer LED bietet vor allem die Erzeugung von weißem Licht mit Hilfe dieses Leuchtstoffs Vorteile. Dies geschieht entweder bei einer UV-emittierenden LED als primäre Lichtquelle unter Verwendung mindestens zweier, bevorzugt dreier Leuchtstoffe. Eine Alternative ist die Verwendung einer blau emittierenden LED sowie eines oder zweier Leuchtstoffe. Hervorragende Ergebnisse werden mit einer Mischung von thermisch stabilem Granatleuchtstoff, bevorzugt YAG:Ce, und einem Eu-dotiertem Sialon erzielt.

Weißes Licht mit guter Farbwiedergabe wird auch erzeugt durch die Kombination einer blauen LED (z.B. Primäremission bei 450 bis 485 nm), eines Grünleuchtstoffs (Emission zwischen 490-525 nm) und eines Gelb-Orange (GO) emittierenden Leuchtstoffs (Emission: 540- 620 nm).

Als GO-Leuchtstoff wird M_{p/2}Si_{12-p-q}Al_{p+q}O_{q}N_{16-q}:Eu²⁺ verwendet. Dabei ist M = Ca einzeln oder in Kombination mit Sr und/oder Mg. Dieser GO-Leuchtstoff hat eine hervorragende Thermostabilität und zeigt ein ausgezeichnetes Lumineszenzverhalten bei höheren Temperaturen, wie sie für LEDs typisch sind: bis 80°C zeigt er im Rahmen der Messgenauigkeit keinen Rückgang der Lumineszenz. Im Vergleich dazu weisen die herkömmlichen Gelbleuchtstoffe bei 80°C einen deutlich messbaren Rückgang der Lumineszenz auf: er beträgt 5 % für YAG und 10-20 % für (Y,Gd)AG.

Gute Farbwiedergaben über Ra=75 erzielen insbesondere, bei Verwendung einer blauen LED als primäre Lichtquelle, Mischungen eines Eu-dotierten Sialons mit einem Chlorosilikat (Eu-dotiert oder Eu,Mn-dotiert), oder mit SrAl₂O₄:Eu²⁺. Im Vergleich zu einer Mischung aus YAG und (Y,Gd)AG ist die Farbwiedergabe fast gleich hoch; die Effizienz sogar etwas höher und das thermisches Löschverhalten deutlich besser. Die Farbwiedergabe im Roten kann nach Bedarf noch verbessert werden durch Zugabe eines Rotleuchtstoffs, z.B. Sr₂Si₅N₈:Eu²⁺ oder SrS:Eu²⁺.

Eine weitere Möglichkeit ist der Einsatz des Eu-dotierten Sialons als einziger Leuchtstoff bei Anregung durch eine blau emittierende LED (Peakemission bei etwa 470 bis 485 nm).

Abhängig von Eu²⁺-Gehalt ist die Körperfarbe dieses Materials leichtgelb bis tief gelb/gelb-orange. Wegen der hervorragenden Temperaturstabilität und auch mechanischen Stabilität ist diese Eu-Sialon gut geeignet als umweltfreundliches gelbes oder gelb-oranges Pigment. Dies gilt insbesondere dann, wenn M durch mehr als 10 % Eu ersetzt ist.

### Figuren

Im folgenden soll die Erfindung anhand mehrerer Ausführungsbeispiele näher erläutert werden. Es zeigen:
- Figur 1: ein Halbleiterbauelement, das als Lichtquelle (LED) für weißes Licht dient;
- Figur 2: eine Beleuchtungseinheit mit Leuchtstoffen gemäß der vorliegenden Erfindung;
- Figur 3 bis 5: das Emissionsspektrum und Reflexionsspektrum von verschiedenen Sialon-Leuchtstoffen gemäß der vorliegenden Erfindung;
- Figur 6: a) das Temperaturverhalten von Sialon HU13/01 absolut sowie b) das Temperaturverhalten von Granat-Leuchtstoffen und Sialon-Leuchtstoff im Vergleich;
- Figur 7: das Emissionsspektrum einer LED mit den Leuchtstoffen YAG und Sialon gemäß der vorliegenden Erfindung.

### Beschreibung der Zeichnungen

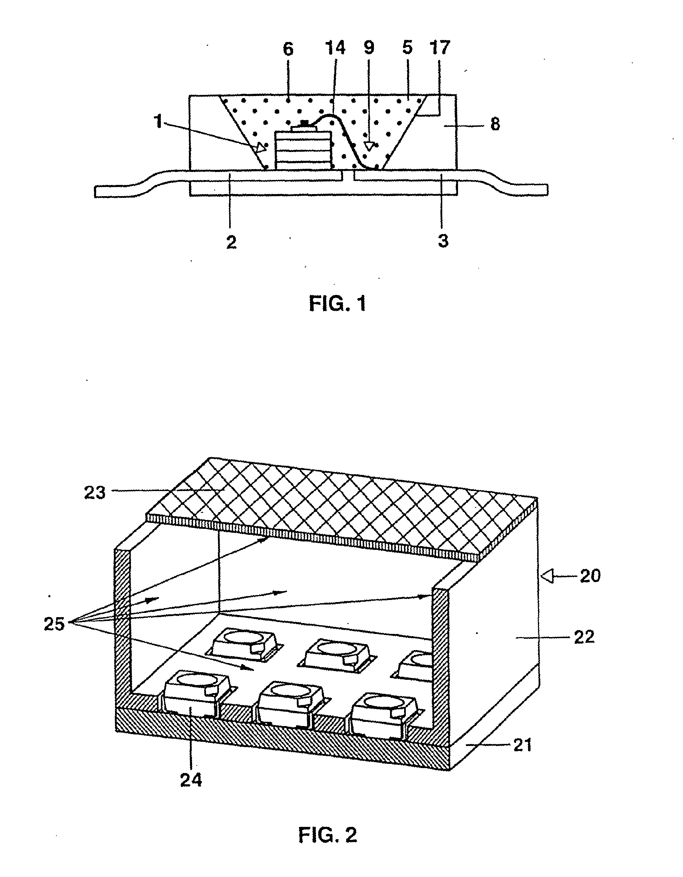

Für den Einsatz in einer weißen LED zusammen mit einem GaInN-Chip wird beispielsweise ein Aufbau ähnlich wie in US 5 998 925 beschrieben verwendet. Der Aufbau einer derartigen Lichtquelle für weißes Licht ist in Figur 1 explizit gezeigt. Die Lichtquelle ist ein Halbleiterbauelement (Chip 1) des Typs InGaN mit einer Peak-Emissionswellenlänge von 460 nm mit einem ersten und zweiten elektrischen Anschluss 2,3, das in ein lichtundurchlässiges Grundgehäuse 8 im Bereich einer Ausnehmung 9 eingebettet ist. Einer der Anschlüsse 3 ist über einen Bonddraht 14 mit dem Chip 1 verbunden. Die Ausnehmung hat eine Wand 17, die als Reflektor für die blaue Primärstrahlung des Chips 1 dient. Die Ausnehmung 9 ist mit einer Vergussmasse 5 gefüllt, die als Hauptbestandteile ein Epoxidgießharz (80 bis 90 Gew.-%) und Leuchtstoffpigmente 6 (weniger als 15 Gew.-%) enthält. Weitere geringe Anteile entfallen u.a. auf Methylether und Aerosil. Die Leuchtstoffpigmente sind eine Mischung aus YAG:Ce- und Sialon-Pigmenten.

In Figur 2 ist ein Ausschnitt aus einer Flächenleuchte 20 als Beleuchtungseinheit gezeigt. Sie besteht aus einem gemeinsamen Träger 21, auf den ein quaderförmiges äußeres Gehäuse 22 aufgeklebt ist. Seine Oberseite ist mit einer gemeinsamen Abdeckung 23 versehen. Das quaderförmige Gehäuse besitzt Aussparungen, in denen einzelne Halbleiter-Bauelemente 24 untergebracht sind. Die Umwandlung in weißes Licht erfolgt mittels Konversionsschichten, die direkt im Gießharz der einzelnen LED sitzen ähnlich wie in Figur 1 beschrieben oder Schichten 25, die auf allen der UV-Strahlung zugänglichen Flächen angebracht sind. Dazu zählen die innen liegenden Oberflächen der Seitenwände des Gehäuses, der Abdeckung und des Bodenteils. Die Konversionsschichten 25 bestehen aus drei Leuchtstoffen, die im gelben, grünen und blauen Spektralbereich emittieren unter Benutzung der erfindungsgemäßen Leuchtstoffe.

Einige Leuchtstoffe des Sialon-Typs sind in Tab. 1 zusammengefasst. Es handelt sich überwiegend um Ca-Sialone des Typs Ca_{1,5}Si₉Al₃N₁₆, wobei ein Anteil des Kations Ca, der zwischen 1 und 10 mol-% liegt, durch Eu ersetzt ist. Typische Quanteneffizienzen dieser Leuchtstoffe liegen bei 70 bis 80 %, wobei sich die Peakemission von 580 nm bei geringer Eu-Dotierung zu etwa 590 nm bei hoher Eu-Dotierung verschiebt.

Gute Ergebnisse lassen sich auch bei Ca-Sialonen des Typs CaSi₁₀Al₂N₁₆ erzielen. Eine hohe Quanteneffizienz über 80 % wird hier auch bei relativ hoher Eu-Dotierung erzielt. Die Peakwellenlänge liegt infolge des geringeren Ca-Anteils überraschend bei kürzeren Wellenlängen. Hiermit kann die Emission gezielt festgelegt werden, evtl. in Kombination mit der Möglichkeit, die Lage der Emission auch durch den Eu-Gehalt zu beeinflussen. Um ausreichend Absorption zu erzielen, kann bei niedrigem Ca-Gehalt auch zwischen 10 und 25 % Eu für Ca, bevorzugt 10 bis 15 %, ausgetauscht werden.

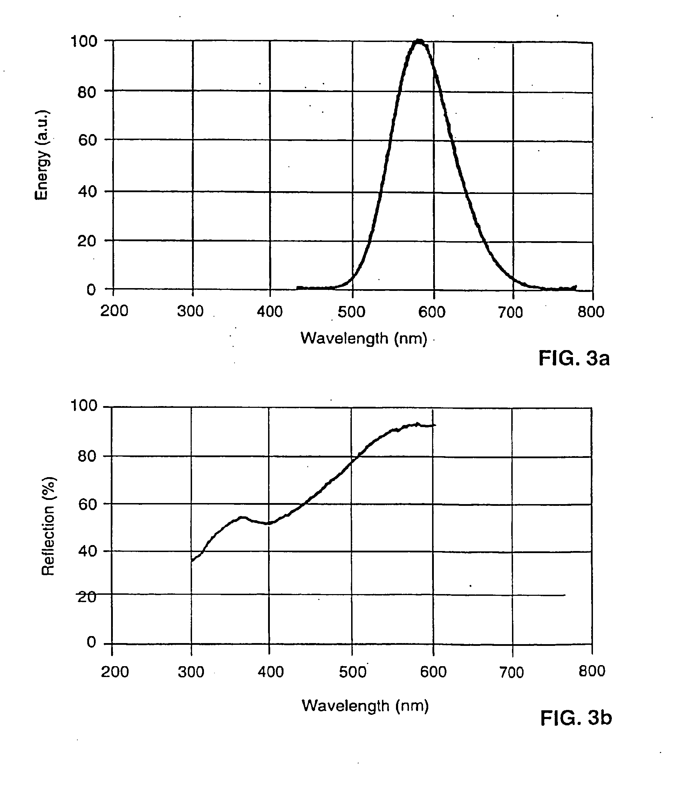

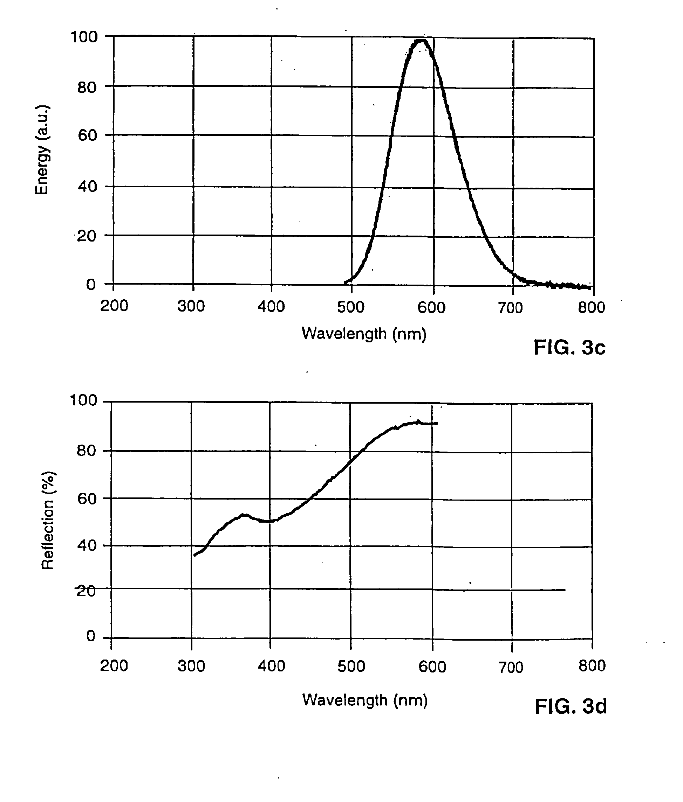

Fig. 3 bis 5 zeigt die Emission und das Reflexionsverhalten verschiedener Sialone als Funktion der Wellenlänge.

Im einzelnen zeigt Figur 3a das Emissionsspektrum des Sialons Ca1.5Al3Si9N16:Eu2+ (2%) (Versuchsnummer HU13/01) bei Anregung durch 400 nm. Das Maximum liegt bei 579 nm, die mittlere Wellenlänge bei 590 nm. Die Quanteneffizienz QE ist 79%. Die Reflexion (Figur 3b) beträgt bei 400 nm etwa R400 = 51% und bei 460 nm etwa R460 = 64 %. Diese Daten sind auch in Tab. 1 aufgelistet, zusammen mit einer Reihe weiterer Leuchtstoffe.

Weiterhin zeigt Figur 3c das Emissionsspektrum dieses Sialons Ca_{1.5}Al₃Si₉N₁₆:Eu²⁺ (2%) (Versuchsnummer HU13/01) bei Anregung durch 460 nm. Das Maximum liegt bei 590 nm, die mittlere Wellenlänge bei 597 nm. Die Quanteneffizienz QE ist 78%. Die Reflexion (Figur 3d) beträgt bei 400 nm etwa R400 = 51% und bei 460 nm etwa R460 = 64 %.

Die Synthese des Sialons HU13/01 wird im folgenden beispielhaft genauer beschrieben.

Das Leuchtstoffpulver wird durch eine Hochtemperatur-Festkörperreaktion hergestellt. Dazu werden beispielsweise die hochreinen Ausgangsmaterialien Ca₃N2, AIN, und Si₃N₄ zusammengemischt mit einem Mol-Verhältnis von 1,5:3:9. Die Korngröße des Si₃N₄ liegt bei d₅₀ = 1,6 µm mit d₁₀ = 0,4 und d₉₀ = 3,9 µm. Eine kleine Menge Eu₂O₃ wird zum Zwecke der Dotierung hinzugefügt und ersetzt dabei die entsprechende Molmenge Ca₃N₂. Dies entspricht bei einem 2 mol-% Anteil des Eu der Bruttoformel (Ca_{1.47}Eu_{0.03})Al₃Si₉N₁₆. Aufgrund der Sauerstoffzugabe zusammen mit dem Eu als Eu-Oxid ist die exakte Bruttoformel als (Ca_{1.47}Eu_{0,03}Al₃Si₉O_{0,045}N_{15,97} anzusehen. Dabei ist also die allgemeine Bruttoformel M_{p/2}Si_{12-p-q}Al_{p+q}O_{1,5q}N_{16-q}:Eu²⁺.

Nachdem die einzelnen Komponenten gut vermischt worden sind, wird das Pulver bei ca. 1700 °C für 1 - 2 h in einer reduzierenden Atmosphäre (N₂/H2) erhitzt und reagiert so zu der oben angegebenen Verbindung.

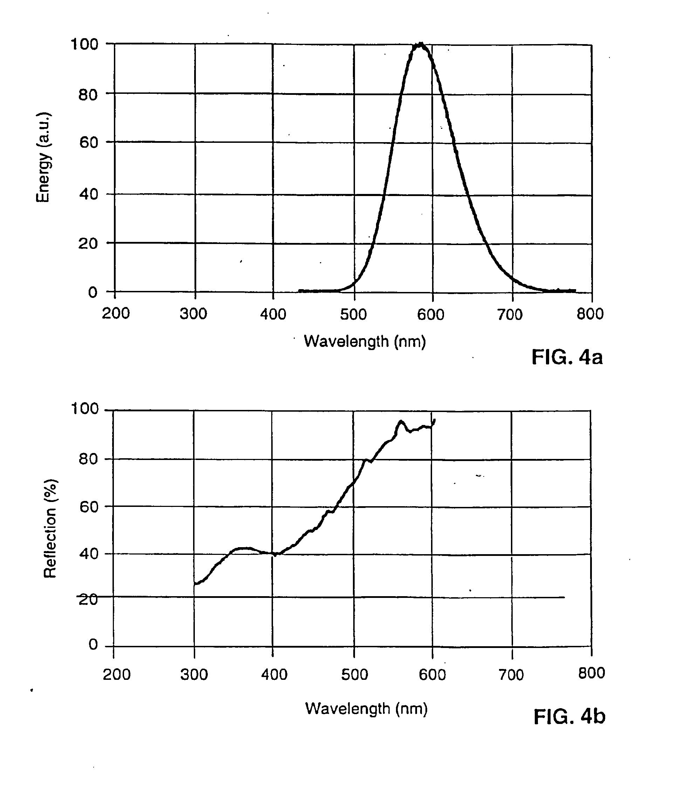

Figur 4 zeigt das Emissionsspektrum des Sialons Ca_{1.5}Al₃Si₉N₁₆:Eu²⁺ (4%) (Versuchsnummer HU14/01) bei Anregung durch 400 nm. Das Maximum liegt bei 588 nm, die mittlere Wellenlänge bei 595 nm. Die Quanteneffizienz QE ist 76%. Die Reflexion (Figur 4b) beträgt bei 400 nm etwa R400 = 40% und bei 460 nm etwa R460 = 54 %.

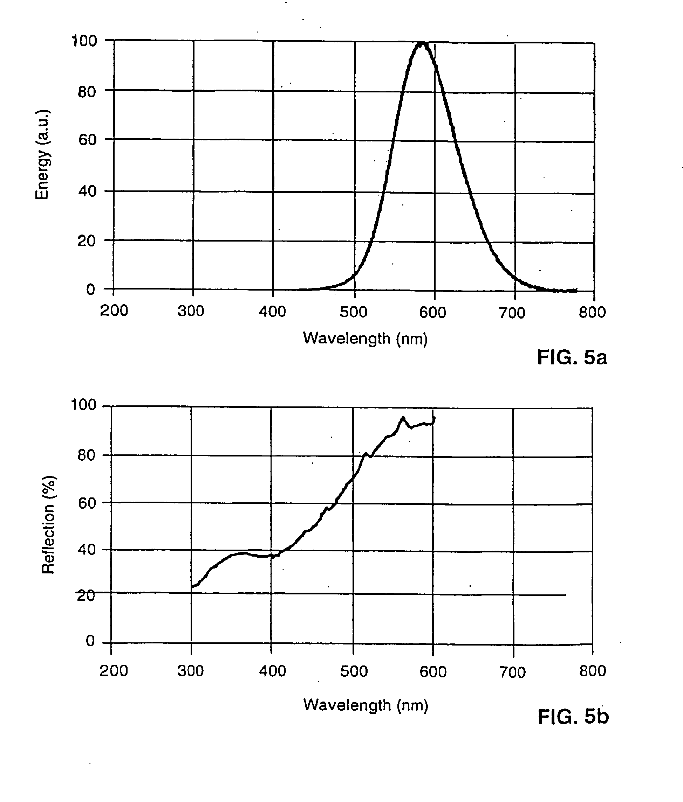

Figur 5 zeigt das Emissionsspektrum des Sialons CaSr_{0.5}Al₃Si₉N₁₆:Eu²⁺ (4%) (Versuchsnummer HU15/01) bei Anregung durch 400 nm. Das Maximum liegt bei 588 nm, die mittlere Wellenlänge bei 594 nm. Die Quanteneffizienz QE ist 70%. Die Reflexion (Figur 4b) beträgt bei 400 nm etwa R400 = 36% und bei 460 nm etwa R460 = 50 %.

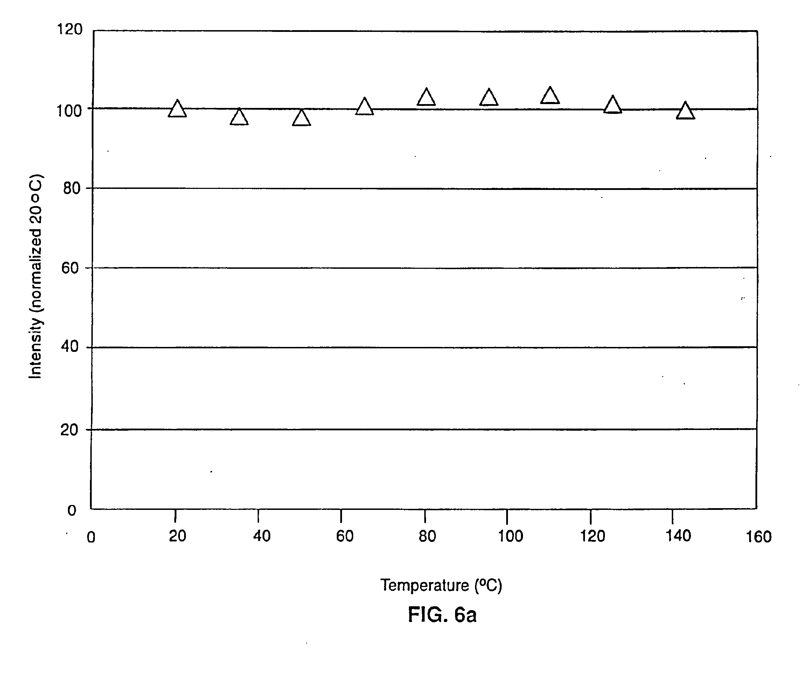

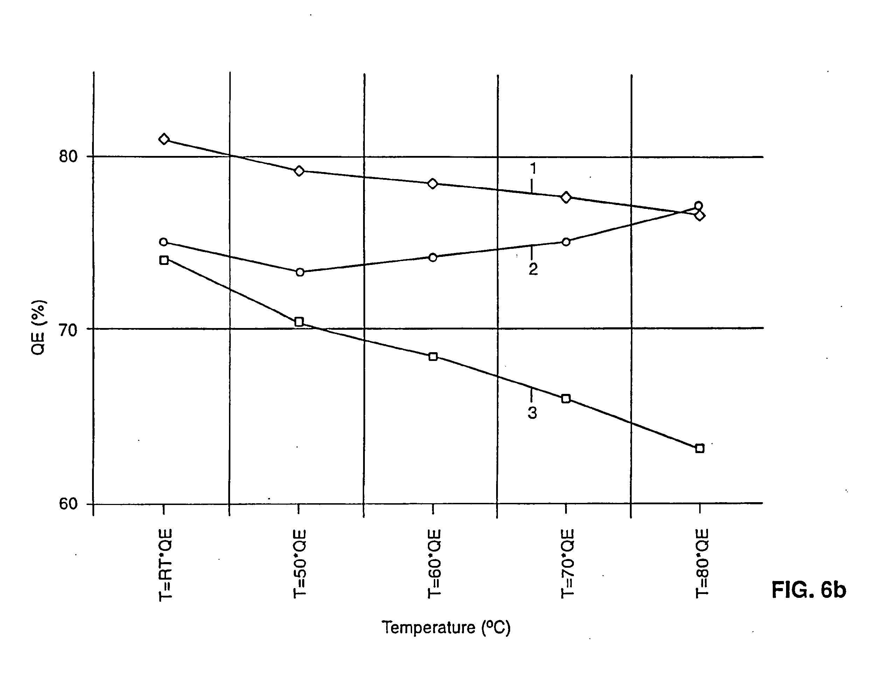

In Figur 6 ist die Quanteneffizienz als Funktion der Temperatur für verschiedene Leuchtstoffe dargestellt. Es zeigt sich, dass reiner YAG:Ce (Kurve 1) zwar eine merklich höhere Quanteneffizienz bei Raumtemperatur aufweist als ein typisches Sialon (Kurve 2: hier HU16/01 aus Tab. 1), nämlich 81 % gegenüber 75 %. Erstaunlicherweise gleicht sich aber die Quanteneffizienz im Betrieb der LED unter typischen Temperaturbelastungen von 80°C vollständig an. Während die Eu-dotierten Sialon-Leuchtstoffe also auf den ersten Blick nur durchschnittliche Ergebnisse (bei Raumtemperatur) zu liefern scheinen, ist ihre Eignung für Lukoleds und andere temperaturbelastete Beleuchtungseinheiten mit dem als Standard verwendeten YAG:Ce direkt vergleichbar. Normalerweise wird in solchen Beleuchtungseinheiten immer auch ein durch Gd modifizierter Granat mitverwendet um die Farbwiedergabe zu verbessern. Im Gegensatz zu reinem YAG:Ce führt aber eine Modifizierung des YAG:Ce (50 mol-% Gd statt Y) bereits zu deutlich schlechteren Ergebnissen unter Temperaturbelastung.

**Tab. 1**

| Verbindung | Kurzbezeichnung | QE | R370 | R400 | R460 | Max. Em | x | y |
|---|---|---|---|---|---|---|---|---|
| Ca1.5AI3Si9N16:Eu2+ (2%) | HU13/01 | 79 | | 51 | 64 | 580 | 0,498 | 0,490 |
| Ca1.5Al3Si9N16:Eu2+ (4%) | HU14/01 | 76 | | 40 | 54 | 588 | 0,515 | 0,477 |
| Ca1.5AI3Si9N16:Eu2+ (4%) | HU16/01 | 75 | | 41 | 57 | 583 | 0,510 | 0,481 |
| Ca1.5AI3Si9N16:Eu2+ (6%) | HU33/01 | 76 | | 39 | 54 | 587 | 0,518 | 0,474 |
| Ca1.5AI3Si9N16:Eu2+ (8%) | HU34/01 | 70 | | 36 | 48 | 588 | 0,525 | 0,468 |
| CaAl2Si10N16:Eu2+ (6%) | HU54/01 | 81 | 56 | 57 | 71 | 576 | 0,479 | 0,504 |
| CaSr0.5Al3Si9N16:Eu2+ (4%) | HU15/01 | 70 | | 36 | 50 | 588 | 0,508 | 0,479 |
| Ca1.5Al3.5Si8.5O0.5N15.5:Eu2+ (4%) | HU56/01 | 64 | 55 | 55 | 67 | 582 | 0,488 | 0,496 |
| Ca1.5Al2.7Ga0.3Si9N16:Eu2+ (8%) | TF39/01 | 43 | 16 | 18 | 30 | 594 | 0,530 | 0,463 |
| Sr1.5Al3Si9N16:Eu2+(4%) | HU19/01 | 41 | 44 | 49 | 62 | 512 | 0,307 | 0,509 |

**Tab. 2**

| Leuchtstoff | Llchtausbeute relativ zu YAG:Ce | Ra | Farbkoord. x | Farbkoord. Y |
|---|---|---|---|---|
| YAG:Ce | 100% | 79 | 0,304 | 0,326 |
| YAG:Ce und (Y,Gd)AG:Ce | 95% | 83 | 0,320 | 0,310 |
| YAG:Ce und Sialon HU34/01 | 106% | 81 | 0,319 | 0,311 |
| TbAG:Ce und Sialon HU34/01 | 100% | 83 | 0,336 | 0,305 |
| Chlorosilikat und Sialon HU34/01 | 104% | 82 | 0,325 | 0,309 |

Dies zeigt die besondere Eignung der Eu-dotierten Sialone für den Einsatz in Lumineszenzkonversions-LEDs und dabei insbesondere in Leuchtstoff-Mischungen zusammen mit YAG:Ce oder anderen temperaturstabilen Leuchtstoffen.

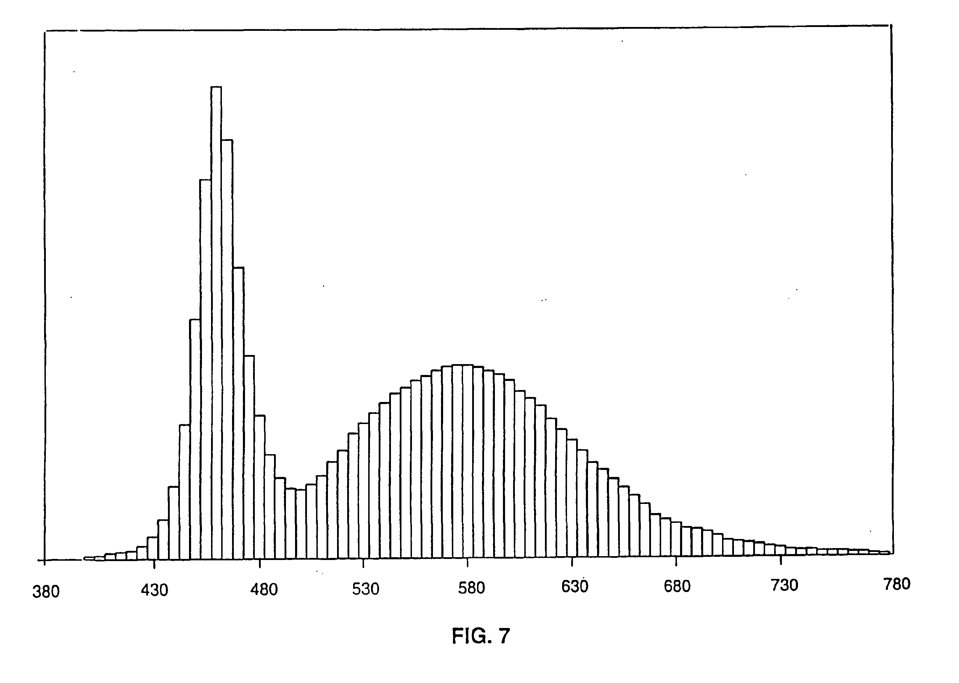

Fig. 7 zeigt das Emissionsspektrum einer Lumineszenzkonversions-LED (Lukoled) basierend auf einer blauen InGaN-LED mit Primäremission bei 460 nm unter Verwendung einer Mischung von YAG:Ce und einem Eu-dotierten Sialon HU34/01 aus Tab. 1. Dabei ist die Farbwiedergabe zwar etwas schlechter als bei einer entsprechenden Mischung YAG:Ce und (Y,Gd)AG:Ce, jedoch ist die Effizienz um 6 % höher. Im Vergleich dazu ist bei ausschließlicher Verwendung von YAG:Ce als Leuchtstoff sowohl die Lichtausbeute als auch die Farbwiedergabe deutlich schlechter, siehe hierzu Tab. 2.

Weiterhin ist in Tab. 2 aufgeführt, dass auch andere Leuchtstoffe mit Sialon gemischt eine hohe Effizienz zeigen. Dies gilt insbesondere für eine Mischung mit Cedotiertem TbAG oder mit Eu-dotiertem Chlorosilikat (siehe beispielsweise DE-GM 201 08 013.3, wo beide Leuchtstoffe mit weiteren Querverweisen näher beschrieben sind). Je nach relativem Anteil lassen sich dabei bekanntlich verschiedene Farborte auf der Verbindungslinie zwischen den Farbörtern der reinen Leuchtstoffe erzielen.

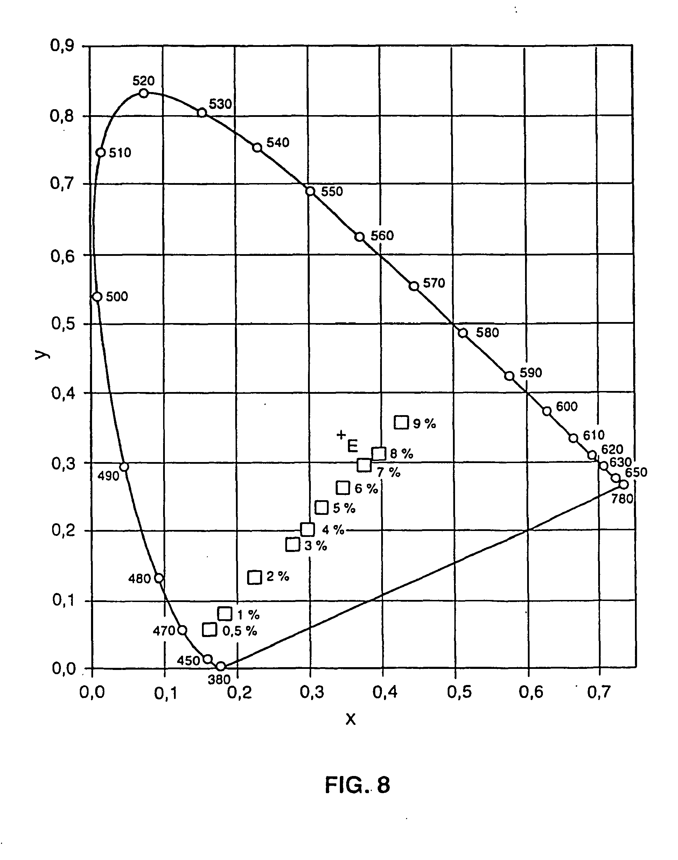

Fig. 8 zeigt die Farbörter einer Mischung zwischen einer blauen LED (460 nm) und einem GO-Leuchtstoff allein bei Mischungsanteilen von 0,5 bis 9 % des GO-Leuchtstoffs. Damit lässt sich eine farbige LED gewünschter Farbe realisieren. Es lassen sich Farborte auf der Verbindungslinie (abgesehen von Sekundäreffekten wie einem geringen Einfluss des Gießharzes) erreichen, die im Blauen, Pinkfarbenen bis hin zum Gelborangen liegen.

## Patentansprüche

1. Beleuchtungseinheit mit mindestens einer LED als Lichtquelle, wobei die LED primäre Strahlung im Bereich **430** bis 485 nm emittiert, wobei diese Strahlung teilweise oder vollständig in längerwellige Strahlung konvertiert wird durch Leuchtstoffe, die der primären Strahlung der LED ausgesetzt sind, **dadurch gekennzeichnet, dass** die Konversion zumindest unter Zuhilfenahme eines Leuchtstoffs, der gelb-orange mit einer Wellenlänge der Peakemission bei 540 bis 620 nm emittiert und der aus der Klasse der Eu-aktivierten Sialone stammt, wobei das Sialon der Formel M_{p/2}Si_{12-p-q}Al_{p+q}O_{q}N_{16-q}:Eu²⁺ gehorcht, mit M= Ca einzeln oder in Kombination mit mindestens einem der Metalle Sr oder Mg, mit q = 0 bis 2,5 und p = 0,5 bis 3.

2. Beleuchtungseinheit nach Anspruch 1, **dadurch gekennzeichnet, dass** das Al teilweise (bis zu 20 mol-%) durch Ga ersetzt ist.

3. Beleuchtungseinheit nach Anspruch 1, **dadurch gekennzeichnet, dass** q < 1 und/oder p = 2 bis 3 gewählt ist.

4. Beleuchtungseinheit nach Anspruch 1, **dadurch gekennzeichnet, dass** der mittlere Korndurchmesser des Leuchtstoffpulvers zwischen 0,5 und 5 µm gewählt ist.

5. Beleuchtungseinheit nach Anspruch 1, **dadurch gekennzeichnet, dass** zur Erzeugung von weißem Licht die primär emittierte Strahlung im blauen Wellenlängenbereich von 430 bis 470 nm liegt, wobei die primär emittierte blaue Strahlung zwei Leuchtstoffen mit Emissionsmaximum im Gelb-Orangen (545 nm bis 590 nm) und im Grünen (490 bis 525 nm) entsprechend einem der vorherigen Ansprüche ausgesetzt wird.

6. Beleuchtungseinheit nach Anspruch 1, **dadurch gekennzeichnet, dass** zur Erzeugung von farbigem Licht die primär emittierte Strahlung im blauen Wellenlängenbereich von 430 bis 485 nm liegt, wobei die primär emittierte blaue Strahlung einem einzigen Leuchtstoff mit Emissionsmaximum im Gelb-Orangen (545 nm bis 590 nm) entsprechend einem der vorherigen Ansprüche ausgesetzt wird.

7. Beleuchtungseinheit nach Anspruch **6**, **dadurch gekennzeichnet, dass** der Mischungsanteil des Gelb-Orange-Leuchtstoffs etwa 0,5 bis 15 % beträgt.

8. Beleuchtungseinheit nach Anspruch 1, **dadurch gekennzeichnet, dass** als primäre Strahlungsquelle eine kurzwellig emittierende Leuchtdiode, insbesondere auf Basis von Ga(In)N, verwendet wird.

9. Beleuchtungseinheit nach Anspruch 1, **dadurch gekennzeichnet, dass** der Anteil des Sr u/o Mg höchstens 40 mol-% des Kations M ausmacht.

10. Beleuchtungseinheit nach Anspruch 1, **dadurch gekennzeichnet, dass** die Beleuchtungseinheit eine Lumineszenzkonversions-LED ist, bei der die Leuchtstoffe direkt oder mittelbar in Kontakt mit dem Chip stehen.

11. Beleuchtungseinheit nach Anspruch 1, **dadurch gekennzeichnet, dass** die Beleuchtungseinheit ein Feld (Array) von LEDs ist.

12. Beleuchtungseinheit nach Anspruch **11, dadurch gekennzeichnet, dass** zumindest einer der Leuchtstoffe auf einer vor dem LED-Feld angebrachten optischen Vorrichtung angebracht ist.

## Claims

1. Illumination unit having at least one LED as light source, the LED emitting primary radiation in the range from 430 to 485 nm, this radiation being partially or completely converted into longer-wave radiation by phosphors which are exposed to the primary radiation of the LED, **characterized in that** the conversion takes place at least with the aid of a phosphor which emits yellow-orange with a peak emission wavelength at 540 to 620 nm and originates from the class of the Eu-activated sialons, the sialon corresponding to the formula M_{p/2}Si_{12-p-q}Al_{p+q}O_{q}N_{16-q}:Eu²⁺, where M = Ca individually or in combination with at least one of the metals Sr or Mg, where q = 0 to 2.5 and p = 0.5 to 3.

2. Illumination unit according to Claim 1, **characterized in that** the Al is partially (up to 20 mol%) replaced by Ga.

3. Illumination unit according to Claim 1, **characterized in that** q < 1 and/or p = 2 to 3 is selected.

4. Illumination unit according to Claim 1, **characterized in that** the mean grain diameter of the phosphor powder is selected to be between 0.5 and 5 µm.

5. Illumination unit according to Claim 1, **characterized in that**, to generate white light, the primary radiation emitted lies in the blue wavelength region of 430 to 470 nm, the primary blue radiation emitted being exposed to two phosphors with an emission maximum in the yellow-orange (545 nm to 590 nm) and in the green (490 to 525 nm) in accordance with one of the preceding claims.

6. Illumination unit according to Claim 1, **characterized in that**, to generate colored light, the primary radiation emitted lies in the blue wavelength region from 430 to 485 nm, the primary blue radiation emitted being exposed to a single phosphor having an emission maximum in the yellow-orange (545 nm to 590 nm) in accordance with one of the preceding claims.

7. Illumination unit according to Claim 6, **characterized in that** the proportion of the yellow-orange phosphor in the mixture is approximately 0.5 to 15%.

8. Illumination unit according to Claim 1, **characterized in that** the primary radiation source used is a light-emitting diode which emits at a short wavelength and is based in particular on Ga(In)N.

9. Illumination unit according to Claim 1, **characterized in that** the proportion of the Sr and/or Mg amounts to at most 40 mol% of the cation M.

10. Illumination unit according to Claim 1, **characterized in that** the illumination unit is a luminescence conversion LED, in which the phosphors are in direct or indirect contact with the chip.

11. Illumination unit according to Claim 1, **characterized in that** the illumination unit is an array of LEDs.

12. Illumination unit according to Claim 11, **characterized in that** at least one of the phosphors is applied to an optical device arranged in front of the LED array.

## Revendications

1. Unité d'éclairage comprenant au moins une DEL comme source lumineuse, la DEL émettant du rayonnement primaire dans le domaine de **430** à 485 nm, ce rayonnement étant transformé en partie ou complètement en du rayonnement de longueur d'onde plus grande par des substances luminescentes, qui sont exposées au rayonnement primaire de la DEL, **caractérisée en ce que** la transformation s'effectue au moins en s'aidant d'une substance luminescente, qui émet dans le jaune-orange en ayant une longueur d'onde de l'émission de crête entre 540 et 620 nm et qui provient de la classe des sialons activés par Eu, le sialon répondant à la formule M_{p/2}Si_{12-p-q}Al_{p+q}O_{q}N_{16-q}:Eu²⁺, dans laquelle M = Ca individuellement ou en combinaison avec au moins l'un des métaux Sr ou Mg, q = 0 à 2,5 et p = 0,5 à 3.

2. Unité d'éclairage suivant la revendication 1, **caractérisée en ce que** l'Al est remplacée en partie ( jusqu'à 20 % en moll ) par du Ga.

3. Unité d'éclairage suivant la revendication 1, **caractérisée en ce que** q < 1 et/ou p = 2 à 3.

4. Unité d'éclairage suivant la revendication 1, **caractérisée en ce que** le diamètre moyen de grain de la poudre de substance luminescente est compris entre 0,5 et 5 µm.

5. Unité d'éclairage suivant la revendication 1, **caractérisée en ce que**, pour la production de lumière blanche, le rayonnement émis de manière primaire est dans le domaine bleu des longueurs d'onde allant de 430 à 470 nm, le rayonnement bleu émis de manière primaire étant soumis à deux substances luminescentes ayant un maximum d'émission dans le jaune-orange ( de 545 nm à 590 nm ) ou dans le vert ( de 490 à 525 nm ) conformément à l'une des revendications précédentes.

6. Unité d'éclairage suivant la revendication 1, **caractérisée en ce que**, pour la production de lumière colorée, le rayonnement émis de manière primaire est dans le domaine bleu des longueurs d'onde allant de 430 à 485 nm, le rayonnement bleu émis de manière primaire étant soumis à une seule substance fluorescente ayant un maximum d'émission dans le jaune-orange ( de 545 nm à 590 nm ) conformément à l'une des revendications précédentes.

7. Unité d'éclairage suivant la revendication **6**, **caractérisée en ce que** la proportion de mélange de la substance luminescente jaune-orange est d'environ 0,5 à 15 %.

8. Unité d'éclairage suivant la revendication 1, **caractérisée en ce que**, comme source de rayonnement primaire, on utilise une diode électroluminescente émettant dans les courtes longueurs d'onde, notamment à base de Ga( In )N.

9. Unité d'éclairage suivant la revendication 1, **caractérisée en ce que** la proportion de Sr et/ou de Mg représente au plus 40 % en moll du cation M.

10. Unité d'éclairage suivant la revendication 1, **caractérisée en ce que** l'unité d'éclairage est une DEL à transformation de luminescence, dans laquelle les substances luminescentes sont en contact direct ou indirect avec la puce.

11. Unité d'éclairage suivant la revendication 1, **caractérisée en ce que** l'unité d'éclairage est un champ ( matrice ) de DEL.

12. Unité d'éclairage suivant la revendication **11, caractérisée en ce qu'**au moins l'une des substances luminescentes est mise sur un dispositif optique placé devant le groupe de DEL.
